# FASCICULE DE BREVET EUROPEEN

(11) **EP 1 805 546 B1**
(45) Date de publication et mention de la délivrance du brevet: **08.10.2014**
(21) Numéro de dépôt: 05812034.6
(22) Date de dépôt: 25.10.2005
(51) Int. Cl.: G02B 26/06, G02B 13/14, G02B 26/08, G03F 7/20

(54) **DISPOSITIF D'IMAGERIE OU D'INSOLATION, NOTAMMENT POUR LA REALISATION D'UN MICRO-CIRCUIT ELECTRONIQUE**
ABBILDUNGS- ODER ISOLATIONSEINRICHTUNG INSBESONDERE ZUR ERZEUGUNG EINER ELEKTRONISCHEN MIKROSCHALTUNG
IMAGING OR INSULATION DEVICE, PARTICULARLY FOR THE CREATION OF AN ELECTRONIC MICRO-CIRCUIT

(30) Priorité: 27.10.2004 FR 0411431
(43) Date de publication de la demande: 11.07.2007
(73) Titulaire: SAGEM DEFENSE SECURITE, 92100 Boulogne Billancourt (FR)
(72) Inventeur: GEYL, Roland, F-94240 L'HAY-LES-ROSES (FR)
(74) Mandataire: Fruchard, Guy
(86) Numéro de dépôt international: PCT/FR2005/002654
(87) Numéro de publication internationale: WO 2006/045945

(56) Documents cités:
- EP-A- 0 744 641
- EP-A- 1 376 192
- US-A- 5 986 795
- US-A1- 2003 147 161
- US-A1- 2003 234 970
- US-A1- 2004 027 632
- US-A1- 2004 202 898

## Description

La présente invention concerne un dispositif d'imagerie ou d'insolation, plus particulièrement bien que non exclusivement pour la réalisation de micro-circuits électroniques.

### ARRIERE PLAN DE L'INVENTION

Il est connu de réaliser simultanément une multitude de micro-circuits électroniques en déposant successivement sur une galette des couches de matière conductrice, semi-conductrice ou isolante qui sont gravées par attaque chimique après une insolation sélective au moyen d'un masque qui détermine les zones insolées pour devenir sensibles à une attaque chimique.

Chaque composant du micro-circuit est obtenu par une superposition de couches en contact les unes avec les autres dans une zone donnée. Pour obtenir une densité importante de composants et une constance des performances des composants réalisés, il est nécessaire que les images des masques utilisés successivement présentent une grande qualité, c'est-à-dire que les traits de l'image soient d'une grande finesse, et une très faible distorsion afin de permettre une mise en correspondance très précise des images successives servant à réaliser la gravure de chaque couche.

Pour la réalisation de micro-circuits électroniques, il est connu d'utiliser un dispositif d'insolation comportant une source de rayonnement émettant un rayonnement, un réticule formé par le masque à reproduire et monté entre la source de rayonnement et un dispositif optique de mise en forme du rayonnement en aval du réticule, le dispositif optique de mise en forme comportant une série de miroirs et/ou de lentilles pour réaliser une image du réticule.

Compte tenu de la densité de composants qui est maintenant recherchée, il est nécessaire de réaliser des images ayant une qualité d'image de l'ordre de quelques dizaines de nanomètres, et pour obtenir une mise en coïncidence satisfaisante des images successives, il est alors nécessaire que la distorsion soit de l'ordre de quelques nanomètres.

Compte tenu des nombreux facteurs perturbateurs au sein de l'optique, notamment des variations de température pouvant survenir au cours de la réalisation des différentes couches du micro-circuit, et des coefficients de dilatation en fonction de la température des matériaux formant le support du dispositif optique, une telle précision ne peut être obtenue qu'à condition de pouvoir compenser les perturbations dimensionnelles du dispositif optique de mise en forme.

A cet effet, on connaît du document US 2004/27632, un dispositif d'imagerie comportant une source de rayonnement émettant un rayonnement, un réticule monté entre la source de rayonnement et un dispositif optique de mise en forme du rayonnement en aval du réticule, le dispositif optique de mise en forme comprenant une série de miroirs pour réaliser une image du réticule, certains des miroirs du dispositif optique de mise en forme étant des miroirs déformables comprenant des organes des déformations reliés à un organe de commande. Dans le mode de réalisation préféré il est prévu dans ce document de contrôler simultanément six miroirs déformables, ce qui implique un système de commande très complexe. Pour rendre le système moins complexe il est proposé un système de commande combinant des actionneurs passifs et des actionneurs actifs. Il n'en reste pas moins très complexe et très coûteux de commander simultanément les six miroirs déformables.

### OBJET DE L'INVENTION

Un but de l'invention est de proposer un dispositif permettant de commander un dispositif d'imagerie de façon satisfaisante tout en limitant le coût de cette commande.

### RESUME DE L'INVENTION

Selon l'invention, on propose un dispositif d'imagerie ou d'insolation du type décrit dans le document précité, dans lequel le nombre de miroirs déformables est strictement limité à deux, l'organe de commande étant associé à un analyseur d'image pour assurer une déformation de l'un des deux miroirs déformables principalement en fonction d'écarts par rapport à une consigne de qualité d'image, et assurer une déformation de l'autre autre miroir déformable principalement en fonction d'écarts par rapport à une consigne de distorsion d'image.

Ainsi, l'analyse et la commande séparées de la qualité d'image et de la distorsion d'image permettent de déclencher des commandes correspondantes plus précises des organes de déformation pour provoquer une déformation des miroirs déformables et corriger les écarts analysés.

Selon des aspects avantageux de l'invention, l'un des miroirs déformables est disposé au voisinage de la pupille du dispositif optique de mise en forme et les organes de déformation correspondants sont commandés principalement en fonction de la consigne de qualité d'image. De préférence, l'autre miroir déformable est un miroir intermédiaire entre la pupille du dispositif optique de mise en forme et l'image, et les organes de déformation correspondants sont de préférence commandés principalement en fonction de la consigne de distorsion d'image.

### BREVE DESCRIPTION DES DESSINS

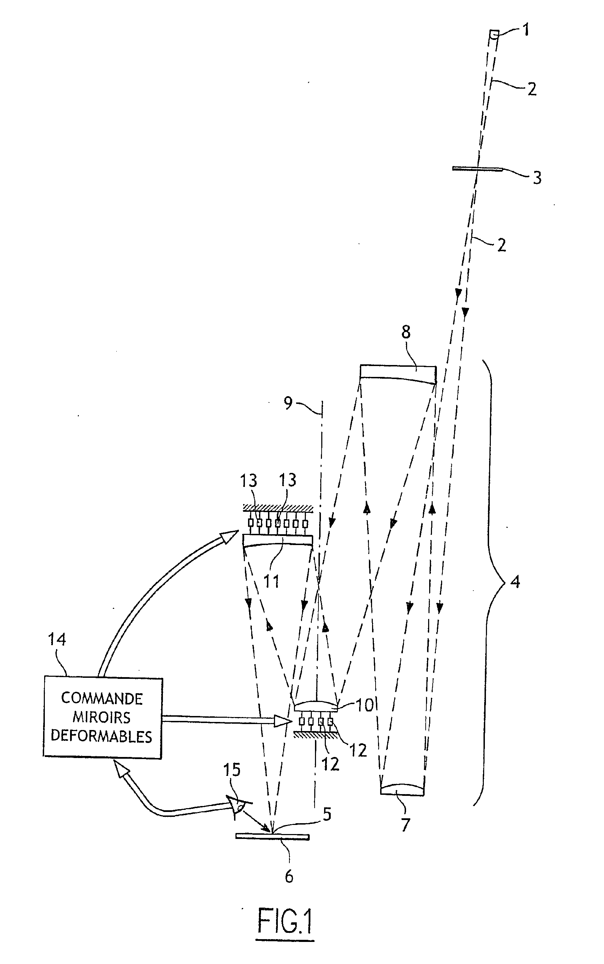

D'autres caractéristiques et avantages de l'invention apparaîtront à la lecture de la description qui suit d'un mode de réalisation particulier non limitatif de l'invention en référence à la figure unique ci-jointe qui est une représentation schématique du dispositif d'insolation selon l'invention.

### DESCRIPTION DETAILLEE DE L'INVENTION

En référence à la figure, le dispositif d'insolation comporte de façon connue en soi une source de rayonnement 1 émettant un rayonnement 2 qui est focalisé sur un réticule 3. Dans le cas d'une réalisation de micro-circuits électroniques présentant une qualité d'image telle que définie ci-dessus, le rayonnement 1 est de préférence un rayonnement ayant une longueur d'onde dans l'Extrême Ultra Violet, par exemple à une longueur d'onde de 13 nanomètres, et le réticule est constitué par le masque définissant le micro-circuit à réaliser sur la couche en cours d'insolation.

De façon également connue en soi, le rayonnement traversant ou réfléchi par le réticule 3 passe à travers un dispositif optique de mise en forme généralement désigné en 4, comportant ici une série de miroirs formant une image 5 sur l'article 6 à insoler, par exemple une galette de silicium.

Selon le mode de réalisation illustré de l'invention, le dispositif optique de mise en forme 4 comporte un premier miroir 7 de structure rigide renvoyant le rayonnement 2 issu du réticule 3 vers un second miroir 8 également de structure rigide. De façon connue en soi les miroirs 7 et 8 sont formés par des segments de miroirs ayant une surface curviligne de révolution autour d'un axe optique 9 du dispositif optique de mise en forme.

En aval du miroir 8 par référence à un trajet du rayonnement 2, le dispositif optique de mise en forme 4 comporte un premier miroir déformable 10 disposé au voisinage de ce que l'homme de l'art appelle la pupille du dispositif optique de mise en forme. En aval du miroir optique 10, le dispositif optique de mise en forme 4 comporte un second miroir déformable 11.

Le miroir déformable 10 comporte des organes de déformation 12 et le miroir déformable 11 comporte des organes de déformation 13. Les organes de déformation 12, 13 sont reliés à un organe de commande 14 servant à commander individuellement chacun des organes de déformation 12, 13. L'organe de commande 14 reçoit des informations provenant d'un analyseur d'image 15 disposé pour analyser l'image 5 en cours ou immédiatement après sa réalisation.

L'organe de commande 14 reçoit des consignes de qualité d'image et de distorsion d'image. Dans une machine de lithographie de type à balayage, lors de l'insolation, un mouvement relatif est effectué entre le réticule 3 et la source de rayonnement 1 pour réaliser un balayage du masque formant le réticule 3. Parallèlement, la galette 6 est déplacée pour réaliser un balayage correspondant de l'image 5 à réaliser sur la galette 6. La réalisation effective de l'image 5 est analysée par l'analyseur d'images 15. Lorsque l'organe de commande 14 constate un écart entre l'image théorique devant être obtenue et l'image observée par l'analyseur 15, l'organe de commande 14 élabore au moyen d'un algorithme d'optimisation inverse, des instructions qui sont transmises aux organes de déformation 12, 13 pour assurer une déformation des miroirs déformables 10, 11, visant à corriger les écarts observés.

De préférence, selon l'invention, le miroir déformable 10 disposé selon la pupille du dispositif optique de mise en forme 4 est commandé principalement en fonction de la consigne de la qualité d'image tandis que le miroir déformable intermédiaire 11 est commandé principalement en fonction de la consigne de distorsion d'image, ce qui permet de mieux dissocier les corrections pour une meilleure efficacité globale.

Afin d'éviter des fluctuations trop rapides de la déformation des miroirs déformables, les organes de déformation sont de préférence commandés selon une cadence inférieure à 1 Hz.

Bien entendu, l'invention n'est pas limitée au mode de réalisation illustré et peut comporter des variantes de réalisation qui apparaîtront à l'homme de métier sans sortir du cadre de l'invention tel que défini par les revendications.

En particulier, bien que le dispositif optique de mise en forme 4 ait été décrit selon un mode de réalisation comportant seulement quatre miroirs, ce dispositif optique de mise en forme peut comporter un nombre plus grand de miroirs, par exemple six miroirs, et peut également comporter des lentilles interposées entre certains miroirs.

Dans le cas où le dispositif optique de mise en forme comporte plusieurs miroirs en aval du miroir disposé selon la pupille du dispositif, le second miroir déformable est de préférence disposé immédiatement en amont de l'image 5.

Bien que le dispositif ait été illustré avec une optimisation incluant seulement une déformation des miroirs déformables 10 et 11, on peut prévoir également un déplacement des autres composants (miroirs ou lentilles) en translation et rotation selon six degrés de liberté possibles.

Bien que dans le mode de réalisation illustré l'analyseur d'image 15 soit disposé pour réaliser une analyse a posteriori de l'image 5, il est également possible, lorsque la configuration optique le permet, de prévoir de prélever des informations de qualité image et de distorsion image par des capteurs placés à des endroits appropriés du trajet du rayonnement en amont de l'image 5, c'est-à-dire pendant la réalisation de l'image.

Bien que l'invention ait été décrite plus particulièrement en relation avec l'insolation d'une galette de micro-circuits électronique, elle peut s'appliquer à toute insolation, ou à tout type d'imagerie.

## Revendications

1. Dispositif d'imagerie ou d'insolation comportant une source de rayonnement (1) émettant un rayonnement (2), un réticule (3) monté entre la source de rayonnement et un dispositif optique de mise en forme (4) du rayonnement en aval du réticule (3), le dispositif optique de mise en forme (4) comprenant une série de miroirs (7, 8, 10, 11) pour réaliser une image (5) du réticule (3), plusieurs des miroirs (10, 11) du dispositif optique de mise en forme (4) étant des miroirs déformables comprenant des organes des déformations (12, 13) reliés à un organe de commande (14), **caractérisé en ce que** le nombre des miroirs déformables est strictement limité à deux, l'organe de commande étant associé à un analyseur d'image (15) pour assurer une déformation de l'un des deux miroirs déformables (10) principalement en fonction d'écarts par rapport à une consigne de qualité d'image, et assurer une déformation de l'autre miroir déformable principalement en fonction d'écarts par rapport à une consigne de distorsion d'image.

2. Dispositif selon la revendication 1, **caractérisé en ce que** l'un des miroirs déformables (10) est disposé selon une pupille du dispositif optique de mise en forme (4) et les organes de déformation (12) correspondants sont commandés principalement en fonction de la consigne de qualité d'image, l'autre miroir déformable (11) étant un miroir intermédiaire entre la pupille du dispositif optique de mise en forme et l'image (5) et étant commandé principalement en fonction de la consigne de distorsion d'image.

3. Dispositif selon la revendication 2, **caractérisé en ce que** le miroir déformable intermédiaire (11) est disposé immédiatement en amont de l'image (5).

4. Dispositif selon la revendication 1, **caractérisé en ce que** les organes de déformation (12, 13) sont commandés selon une cadence inférieure à 1 Hz.

## Patentansprüche

1. Vorrichtung zur Abbildung oder Bestrahlung, umfassend eine Strahlungsquelle (1), die eine Strahlung (2) abgibt, eine Strichplatte (3), die zwischen der Strahlungsquelle und einer optischen Formgebungsvorrichtung (4) zur Formung der Strahlung stromabwärts der Strichplatte (3) montiert ist, wobei die optische Formgebungsvorrichtung (4) eine Reihe von Spiegeln (7, 8, 10, 11) umfasst, um ein Bild (5) der Strichplatte (3) zu erzeugen, wobei mehrere der Spiegel (10, 11) der optischen Formgebungsvorrichtung verformbare Spiegel sind, die Verformungsorgane (12, 13) umfassen, die mit einem Stellorgan (14) verbunden sind, **dadurch gekennzeichnet, dass** die Anzahl der verformbaren Spiegel genau auf zwei begrenzt ist, wobei das Stellorgan mit einem Bildanalysator (15) verbunden ist, um eine Verformung eines der beiden verformbaren Spiegel (10) hauptsächlich in Abhängigkeit von Abweichungen in Bezug auf einen Bildqualitätssollwert sicherzustellen und eine Verformung des anderen verformbaren Spiegels hauptsächlich in Abhängigkeit von Abweichungen in Bezug auf einen Bildverzeichnungssollwert sicherzustellen.

2. Vorrichtung nach Anspruch 1, **dadurch gekennzeichnet, dass** einer der verformbaren Spiegel (10) entsprechend einer Pupille der optischen Formgebungsvorrichtung (4) angeordnet ist und die entsprechenden Verformungsorgane (12) hauptsächlich in Abhängigkeit von dem Bildqualitätssollwert gesteuert werden, wobei der andere verformbare Spiegel (11) ein Zwischenspiegel zwischen der Pupille der optischen Formgebungsvorrichtung und dem Bild (5) ist und hauptsächlich in Abhängigkeit von dem Bildverzeichnungssollwert gesteuert wird.

3. Vorrichtung nach Anspruch 2, **dadurch gekennzeichnet, dass** der verformbare Zwischenspiegel (11) unmittelbar stromaufwärts des Bildes (5) angeordnet ist.

4. Vorrichtung nach Anspruch 1, **dadurch gekennzeichnet, dass** die Verformungsorgane (12, 13) mit einem Takt gesteuert werden, der unter 1 Hz liegt.

## Claims

1. An imaging or exposure device comprising a radiation source (1) emitting radiation (2), a reticle (3) mounted between the radiation source and an optical projection system (4) for shaping the radiation downstream from the reticle (3), the optical projection system (4) comprising a series of mirrors (7, 8, 10, 11) for making an image (5) of the reticle (3), a plurality of mirrors (10, 11) of the optical projection system (4) being deformable mirrors including deformer members (12, 13) connected to a control unit (14), the device being **characterized in that** the number of deformable mirrors is strictly limited to two, the control unit being associated with an image analyzer (15) to deform one of the deformable mirrors (10) mainly as a function of differences relative to an image quality setpoint, and to deform the other deformable mirror mainly as a function of differences relative to an image distortion setpoint.

2. A device according to claim 1, **characterized in that** one of the deformable mirrors (10) is located at the pupil of the optical projection system (4), and the corresponding deformer members (12) are controlled mainly as a function of the image quality setpoint, the other deformable mirror (10) being an intermediate mirror between the pupil of the optical projection system and the image (5) and being controlled mainly as a function of the image distortion setpoint.

3. A device according to claim 2, **characterized in that** the intermediate deformable mirror (11) is disposed immediately upstream of the image (5).

4. A device according to claim 1, **characterized in that** the deformer members (12, 13) are controlled at a rate of less than 1 Hz.
